# EUROPÄISCHE PATENTSCHRIFT

(11) **EP 2 380 218 B1**
(45) Veröffentlichungstag und Bekanntmachung des Hinweises auf die Patenterteilung: **04.05.2016**
(21) Anmeldenummer: 10706165.7
(22) Anmeldetag: 18.01.2010
(51) Int. Cl.: H01L 33/62, H01L 33/48, H01L 33/60, H01L 33/64

(54) **OPTOELEKTONISCHES HALBLEITERBAUTEIL UND VERFAHREN ZUR HERSTELLUNG EINES OPTOELEKTRONISCHEN HALBLEITERBAUTEILS**
OPTOELECTRONIC SEMICONDUCTOR COMPONENT AND METHOD FOR PRODUCING AN OPTOELECTRONIC SEMICONDUCTOR COMPONENT
COMPOSANT À SEMI-CONDUCTEURS OPTOÉLECTRONIQUE ET PROCÉDÉ DE FABRICATION D'UN COMPOSANT À SEMI-CONDUCTEURS OPTOÉLECTRONIQUE

(30) Priorität: 22.01.2009 DE 102009005709
(43) Veröffentlichungstag der Anmeldung: 26.10.2011
(73) Patentinhaber: OSRAM Opto Semiconductors GmbH, 93055 Regensburg (DE)
(72) Erfinder: AHLSTEDT, Magnus, 93049 Regensburg (DE); AHLSTEDT, Mikael, 80686 München (DE); GROLIER, Vincent, 80639 München (DE)
(74) Vertreter: Epping - Hermann - Fischer
(86) Internationale Anmeldenummer: PCT/EP2010/050536
(87) Internationale Veröffentlichungsnummer: WO 2010/084101

(56) Entgegenhaltungen:
- EP-A1- 1 119 058
- US-A- 5 925 898
- US-A1- 2004 012 958
- US-A1- 2004 232 572
- US-A1- 2005 013 562
- US-A1- 2007 145 393

## Beschreibung

Optoelektronisches Halbleiterbauteil und Verfahren zur Herstellung eines optoelektronischen Halbleiterbauteils Es wird ein optoelektronisches Halbleiterbauteil angegeben. Darüber hinaus wird ein Verfahren zur Herstellung eines optoelektronischen Halbleiterbauteils angegeben. Bei dem optoelektronischen Halbleiterbauteil kann es sich beispielsweise um eine Leuchtdiode, eine Laserdiode oder einen optischen Detektor handeln.

US2007/0145393 A1 offenbart ein optoelektronisches Halbleiterbauteil mit einem lichtemittierenden Halbleiterchip, einer Abdeckplatte, die am optoelektronischen Halbleiterchip befestigt ist und die gesamte Strahlungsdurchtrittfläche des Halbleiterchips überspannt, wobei die Abdeckplatte den Halbleiterchip seitlich überragt, einer Kontaktstelle, die an der dem Halbleiterchip zugewandten Seite der Abdeckplatte an der Abdeckplatte befestigt ist, und einen Gehäusekörper, auf dem der Halbleiterchip befestigt ist und eine Gehäuseseitenwand, die den Halbleiterchip seitlich umschließt, wobei die Abdeckplatte an der Gehäuseseitenwand befestigt ist.

Die Erfindung ist in den unabhängigen Ansprüchen 1 und 13 definiert. Bevorzugte Ausführungsbeispiele sind in den abhängigen Ansprüchen angegeben. Gemäß zumindest einer Ausführungsform des optoelektronischen Halbleiterbauteils umfasst das optoelektronische Halbleiterbauteil zumindest einen optoelektronischen Halbleiterchip. Bei dem optoelektronischen Halbleiterchip kann es sich um einen strahlungsemittierenden oder strahlungsempfangenden optoelektronischen Halbleiterchip handeln. Beispielsweise handelt es sich bei dem Halbleiterchip um einen Lumineszenzdiodenchip, wie etwa einen Leuchtdiodenchip oder einen Laserdiodenchip. Darüber hinaus ist es möglich, dass es sich bei dem Halbleiterchip um einen Fotodiodenchip handelt.
Der zumindest eine optoelektronische Halbleiterchip weist eine Strahlungsdurchtrittsfläche auf. Die Strahlungsdurchtrittsfläche ist diejenige Fläche, durch die im Betrieb des optoelektronischen Halbleiterchips die erzeugte elektromagnetische Strahlung austritt oder die zu detektierende elektromagnetische Strahlung eintritt. Die Strahlungsdurchtrittsfläche ist vorzugsweise an einer Hauptfläche des Halbleiterchips ausgebildet. Beispielsweise weist der Halbleiterchip eine quaderförmige Form auf. Die Hauptfläche ist dann durch die Deckfläche des Quaders gebildet. Handelt es sich bei dem optoelektronischen Halbleiterchip um einen strahlungsemittierenden Halbleiterchip, so tritt die erzeugte Strahlung vorzugsweise zumindest im Wesentlichen nur durch die Strahlungsdurchtrittsfläche an dieser Hauptfläche aus und nicht beispielsweise durch die Seitenflächen des Halbleiterchips.

Gemäß zumindest einer Ausführungsform des optoelektronischen Halbleiterbauteils umfasst das Halbleiterbauteil eine Abdeckplatte. Bei der Abdeckplatte handelt es sich um eine strahlungsdurchlässige, starre, selbsttragende Platte. Insbesondere handelt es sich bei der Abdeckplatte nicht um eine Folie, sondern die Abdeckplatte kann mechanisch tragende Eigenschaften im optoelektronischen Halbleiterbauteil übernehmen. Die Abdeckplatte ist am optoelektronischen Halbleiterchip befestigt. Umfasst das optoelektronische Halbleiterbauteil mehrere optoelektronische Halbleiterchips, so sind sämtliche optoelektronische Halbleiterchips an derselben Seite der Abdeckplatte an dieser befestigt.

Die Abdeckplatte überspannt dabei die gesamte Strahlungsdurchtrittsfläche des zumindest einen Halbleiterchips. Das heißt, der zumindest eine Halbleiterchip ist mit seiner Strahlungsdurchtrittsfläche an der Abdeckplatte befestigt, wobei die Abdeckplatte über die Strahlungsdurchtrittsfläche übersteht, so dass sie die gesamte Strahlungsdurchtrittsfläche überdeckt. Die Abdeckplatte ist dem Halbleiterchip an seiner Strahlungsdurchtrittsfläche also in Hauptabstrahlrichtung des Halbleiterchips - falls es sich um einen strahlungserzeugenden Halbleiterchip handelt - nachgeordnet. Vom Halbleiterchip im Betrieb emittierte oder zu detektierende elektromagnetische Strahlung tritt durch die Abdeckplatte. Ferner ist die Abdeckplatte derart groß gewählt, dass sie den Halbleiterchip seitlich überragt. Das heißt, der zumindest eine Halbleiterchip ist beispielsweise in seiner lateralen Ausdehnung kleiner gewählt als die Abdeckplatte, so dass die Abdeckplatte an sämtlichen Seitenflächen des optoelektronischen Halbleiterchips lateral über diesen übersteht. Umfasst das optoelektronische Halbleiterbauteil mehrere optoelektronische Halbleiterchips, so überspannt die Abdeckplatte sämtliche Strahlungsdurchtrittsflächen der Halbleiterchips und überragt alle Halbleiterchips seitlich.

Gemäß zumindest einer Ausführungsform des optoelektronischen Halbleiterbauteils umfasst das Halbleiterbauteil ferner eine Kontaktstelle, die an der dem Halbleiterchip zugewandten Seite der Abdeckplatte an der Abdeckplatte befestigt ist. Über die Kontaktstelle des optoelektronischen Halbleiterbauteils kann der zumindest eine Halbleiterchip elektrisch kontaktiert werden. Die Kontaktstelle ist beispielsweise lateral seitlich vom Halbleiterchip an der gleichen Seite der Abdeckplatte angeordnet wie der Halbleiterchip selbst.

Gemäß zumindest einer Ausführungsform des optoelektronischen Halbleiterbauteils ist die Kontaktstelle des Halbleiterbauteils mittels eines Verbindungselements mit zumindest einer Anschlussstelle des Halbleiterchips elektrisch leitend verbunden. Das heißt, von der Kontaktstelle führt ein Verbindungselement, das sich im elektrischen Kontakt mit der Kontaktstelle befindet zu einer Anschlussstelle des Halbleiterchips. Bei der Anschlussstelle des Halbleiterchips handelt es sich beispielsweise um eine Metallisierung auf der Hauptfläche des Halbleiterchips, welche auch die Strahlungsdurchtrittsfläche des Halbleiterchips umfasst. Das heißt, die Anschlussstelle ist an der Hauptfläche des Halbleiterchips, welche die Strahlungsdurchtrittsfläche des Halbleiterchips umfasst, angeordnet. Von der Anschlussstelle ausgehend können beispielsweise Stromverteilungsbahnen auf der Hauptfläche des Halbleiterchips angeordnet sein, so dass der über die Anschlussstelle eingeprägte Strom über die gesamte Hauptfläche des Halbleiterchips verteilt werden kann.

Gemäß zumindest einer Ausführungsform des optoelektronischen Halbleiterbauteils umfasst das Halbleiterbauteil zumindest einen optoelektronischen Halbleiterchip, der eine Strahlungsdurchtrittsfläche aufweist, wobei die Strahlungsdurchtrittsfläche an einer Hauptfläche des Halbleiterchips ausgebildet ist. Ferner umfasst das Halbleiterbauteil eine Abdeckplatte, die am optoelektronischen Halbleiterchip befestigt ist und die gesamte Strahlungsdurchtrittsfläche des Halbleiterchips überspannt, wobei die Abdeckplatte den Halbleiterchip seitlich überragt. Darüber hinaus umfasst das optoelektronische Halbleiterbauteil eine Kontaktstelle, die an der dem Halbleiterchip zugewandten Seite der Abdeckplatte an der Abdeckplatte befestigt ist, wobei die Kontaktstelle mittels eines Verbindungselements mit zumindest einer Anschlussstelle des Halbleiterchips elektrisch leitend verbunden ist und die Anschlussstelle an der Hauptfläche des Halbleiterchips angeordnet ist, die die Strahlungsdurchtrittsfläche des Halbleiterchips umfasst.

Das Halbleiterbauteil zeichnet sich dabei unter anderem durch die folgenden Vorteile aus:
- Die Abdeckplatte verleiht dem optoelektronischen Halbleiterchip eine mechanische Stabilität, so dass beispielsweise auch optoelektronische Halbleiterchips Verwendung finden können, die kein oder nur ein sehr dünnes Aufwachssubstrat aufweisen. Beispielsweise können die Halbleiterchips lediglich epitaktisch gewachsenen Schichten umfassen und eine Dicke von 20 µm oder weniger aufweisen.
- Die Abdeckplatte an der Strahlungsdurchtrittsfläche des optoelektronischen Halbleiterchips kann zur Abführung von im Betrieb im Halbleiterchip erzeugter Wärme von diesem dienen. Sie wirkt also für den Halbleiterchip als Wärmesenke.
- Der Halbleiterchip kann über ein Verbindungselement elektrisch mit der Kontaktstelle des Halbleiterbauteils verbunden sein, so dass beispielsweise das Verbinden des Halbleiterchips über einen Kontaktdraht (also beispielsweise über so genanntes Wirebonding) entfallen kann. Dies erhöht die mechanische Stabilität des optoelektronischen Halbleiterbauteils. Dadurch kann beispielsweise die mittlere Lebensdauer des optoelektronischen Halbleiterbauteils erhöht sein, da die Gefahr des Abreißens oder Brechens eines Bonddrahts nicht mehr besteht.

Gemäß zumindest einer Ausführungsform des optoelektronischen Halbleiterbauteils ist das Verbindungselement auf der dem Halbleiterchip zugewandten Seite der Abdeckplatte an der Abdeckplatte befestigt. Beispielsweise kann es sich bei dem Verbindungselement um eine Metallisierung handeln, die direkt auf die Abdeckplatte an der Seite der Abdeckplatte aufgebracht ist, die dem Halbleiterchip zugewandt ist. Die Metallisierung kann über Herstellungsverfahren wie Druckprozesse, Aufdampfen, Sputtern, Rakeln oder epitaktische Verfahren auf die Abdeckplatte aufgebracht werden. Das Verbindungselement kann dabei eines der folgenden Materialien enthalten oder aus einem der folgenden Materialien bestehen: Titan, Platin, Silber, Rhodium, Kupfer, Gold, Aluminium. Darüber hinaus ist es möglich, dass das Verbindungselement mit oder aus einem transparenten leitfähigen Oxid (TCO - Transparent Conductive Oxide) gebildet ist. Das Verbindungselement ist dann elektrisch leitend und für im Halbleiterchip erzeugte/detektierte elektromagnetische Strahlung durchlässig, beispielsweise transparent.

Ein Verbindungselement, das als dünne Schicht auf die Abdeckplatte aufgebracht ist, zeichnet sich insbesondere durch eine bessere mechanische Stabilität als beispielsweise ein Drahtkontakt aus.

Gemäß zumindest einer Ausführungsform des optoelektronischen Halbleiterbauteils bedeckt das Verbindungselement die Abdeckplatte an ihrer dem Halbleiterchip zugewandten Seite bis auf einen Bereich in der Strahlungsdurchtrittsfläche des Halbleiterchips vollständig. Das heißt, zumindest direkt über der Strahlungsdurchtrittsfläche des Halbleiterchips ist ein Bereich auf der Abdeckplatte ausgebildet, an dem diese nicht vom Verbindungselement bedeckt ist. Beispielsweise kann die Abdeckplatte im Bereich der gesamten Strahlungsdurchtrittsfläche des Halbleiterchips frei vom Verbindungselement sein. Das Verbindungselement ist dann an denjenigen Stellen der Abdeckplatte ausgebildet, die nicht direkt über der Strahlungsdurchtrittsfläche des Halbleiterchips liegen. Das Verbindungselement kann also direkt über dem Halbleiterchip lediglich auf Bereiche der Abdeckplatte aufgebracht sein, die deckungsgleich sind mit Anschlussstellen des Halbleiterchips auf der Hauptfläche des Halbleiterchips, welche die Strahlungsdurchtrittsfläche umfasst. Dadurch ist sichergestellt, dass der maximal mögliche Anteil der im Betrieb des Halbleiterchips emittierten oder aufzunehmenden Strahlung durch die Strahlungsdurchtrittsfläche in die Abdeckplatte oder von der Abdeckplatte in die Strahlungsdurchtrittsfläche gelangen kann. Andererseits kann das Verbindungselement auf diese Weise besonders großflächig ausgebildet werden, so dass das Verbindungselement beispielsweise durch eine dünne Metallbeschichtung gebildet sein kann, die trotz ihrer geringen Dicke geeignet ist, den Halbleiterchip ausreichend mit Strom zu versorgen.

Gemäß zumindest einer Ausführungsform des optoelektronischen Halbleiterchips ist das Verbindungselement strahlungsdurchlässig oder strahlungsreflektierend ausgebildet. Für den Fall, dass das Verbindungselement strahlungsreflektierend ausgebildet ist, kann es dazu dienen, in die Abdeckplatte eingekoppelte elektromagnetische Strahlung, die beispielsweise vom optoelektronischen Halbleiterchip stammt, zu reflektieren. Das heißt, mit Hilfe des Verbindungselements kann beispielsweise eine Rückreflexion auf Bereiche des Halbleiterbauteils, wie zum Beispiel die Kontaktstelle des Halbleiterbauteils, verhindert werden, wodurch sich die Effizienz des Halbleiterbauteils erhöht.

Gemäß zumindest einer Ausführungsform des optoelektronischen Halbleiterbauteils umschließt das Verbindungselement die Strahlungsdurchtrittsfläche des Halbleiterchips seitlich vollständig. In dieser Ausführungsform ist das Verbindungselement auf der dem Halbleiterchip zugewandten Seite der Abdeckplatte derart aufgebracht, dass die Strahlungsdurchtrittsfläche des Halbleiterchips von ihm rahmenartig umschlossen ist. Beispielsweise kann sich das Verbindungselement an der Hauptfläche des Halbleiterchips, die die Strahlungsdurchtrittsfläche umfasst, in Kontakt mit einer Anschlussstelle oder mehreren Anschlussstellen des Halbleiterchips auf der Hauptfläche befinden. Über das Verbindungselement, das die Strahlungsdurchtrittsfläche seitlich vollständig umschließt, kann somit eine besonders großflächige Kontaktierung des Halbleiterchips erreicht werden.

Gemäß zumindest einer Ausführungsform des optoelektronischen Halbleiterbauteils umschließt die Kontaktstelle des Halbleiterbauteils den Halbleiterchip seitlich vollständig. Diese Ausführungsform erweist sich als besonders vorteilhaft zusammen mit einem Verbindungselement, das die Strahlungsdurchtrittsfläche des Halbleiterchips seitlich vollständig umschließt. Das Verbindungselement stellt dann eine großflächige Verbindung zwischen der oder den Anschlussstellen des Halbleiterchips und der Kontaktstelle des Halbleiterbauteils her. Die Kontaktstelle des Halbleiterbauteils selbst ist großflächig ausgebildet, da sie zum Beispiel die gesamte Strahlungsdurchtrittsfläche des Halbleiterchips seitlich umschließt. Auf diese Weise kann elektrischer Strom besonders gleichmäßig in den Halbleiterchip eingeprägt werden. Die Kontaktstelle kann beispielsweise rahmenförmig ausgebildet sein, wobei sich der Ausdruck "rahmenförmig" nicht auf die geometrische Form der Kontaktstelle beziehen muss. Das heißt, die Kontaktstelle kann rechteckig, rund, oval oder in anderen Formen ausgeführt sein. Wichtig ist in dieser Ausführungsform lediglich, dass die Kontaktstelle den Halbleiterchip seitlich vollständig umgibt.

Gemäß zumindest einer Ausführungsform des optoelektronischen Halbleiterbauteils umfasst die Abdeckplatte einen Lumineszenzkonversionsstoff.

Beispielsweise kann die Abdeckplatte aus einem transparenten Material wie Glas oder Kunststoff gebildet sein, in das, oder auf das ein Lumineszenzkonversionsstoff gebracht ist.

Darüber hinaus ist es möglich, dass es sich bei der Abdeckplatte um ein keramisches Material handelt, in das der Lumineszenzkonversionsstoff eingebracht ist.

Schließlich ist es möglich, dass die Abdeckplatte selbst aus einem keramischen Lumineszenzkonversionsstoff wie beispielsweise YAG:Ce gebildet ist.

Ferner kann der Lumineszenzkonversionsstoff als Schicht auf die Abdeckplatte aufgebracht sein. Vorzugsweise ist der Lumineszenzkonversionsstoff dann auf die dem Halbleiterchip zugewandte Innenseite der Abdeckplatte aufgebracht. Zum Beispiel kann der Lumineszenzkonversionsstoff in Form von Partikeln in eine Silikonschicht eingebracht sein, die auf die Abdeckplatte aufgebracht ist.

Die Abdeckplatte an der Strahlungsdurchtrittsfläche des optoelektronischen Halbleiterchips kann zur Abführung von im Betrieb im Lumineszenzkonversionsstoff erzeugter Wärme von diesem dienen. Sie wirkt also für den Lumineszenzkonversionsstoff als Wärmesenke

Für den Fall, dass die Abdeckplatte einen Lumineszenzkonversionsstoff umfasst, erweist es sich als besonders vorteilhaft, wenn das Verbindungselement strahlungsreflektierend ausgebildet ist und das Verbindungselement die Abdeckplatte an ihrer dem Halbleiterchip zugewandten Seite bis auf einen Bereich an der Strahlungsdurchtrittsfläche des Halbleiterchips vollständig bedeckt. In diesem Fall dient das Verbindungselement also als Spiegel, der auch konvertierte, vom Lumineszenzkonversionsstoff re-emittierte elektromagnetische Strahlung von der Strahlungsdurchtrittsfläche des Halbleiterchips weg reflektieren kann. In diesem Fall ist es insbesondere auch möglich, dass die Abdeckplatte eine von der Quaderform abweichende Form aufweist. Beispielsweise kann die Abdeckplatte im Querschnitt trapezförmig ausgebildet sein. Die Abdeckplatte kann also Seitenflächen umfassen, die in einem Winkel von ≠90°, vorzugsweise von > 90° zur Strahlungsdurchtrittsfläche des Halbleiterchips verlaufen. Beispielsweise können auch die Seitenflächen vollständig mit dem Material des Verbindungselements bedeckt sein, so dass sich durch die Formgebung der Abdeckplatte sowie das reflektierende Verbindungselement eine Reflexion von elektromagnetischer Strahlung, die von der Strahlungsdurchtrittsfläche des Halbleiterchips weg gerichtet ist, ergeben kann.

Das heißt, gemäß zumindest einer Ausführungsform des optoelektronischen Halbleiterbauteils weist die Abdeckplatte zumindest eine Seitenfläche auf, die in einem Winkel > 90° zur Strahlungsdurchtrittsfläche des Halbleiterchips verläuft. Vorzugsweise ist diese Seitenfläche dann mit dem Verbindungselement bedeckt, das strahlungsreflektierend ausgebildet ist. Beispielsweise ist es möglich, dass sämtliche Seitenflächen der Abdeckplatte einen Winkel von > 90° mit der Strahlungsdurchtrittsfläche einschließen und stellenweise oder vollständig mit dem strahlungsreflektierenden Verbindungselement bedeckt sind.

Gemäß zumindest einer Ausführungsform des optoelektronischen Halbleiterbauteils umfasst das Halbleiterbauteil einen Gehäusekörper, der einen Gehäuseboden umfasst, auf welchem der Halbleiterchip befestigt ist, und zumindest eine Gehäuseseitenwand, die den Halbleiterchip seitlich umschließt. Gehäuseseitenwand und Gehäuseboden können dabei aus dem gleichen Material bestehen und sind zum Beispiel einstückig miteinander ausgebildet. Beispielsweise sind Gehäuseseitenwand und Gehäuseboden dadurch erzeugt, dass in einen Vollkörper eine Ausnehmung strukturiert ist. Die Bodenfläche der Ausnehmung bildet den Gehäuseboden des Gehäusekörpers, die Seitenflächen der Ausnehmung bilden die Gehäuseseitenwände des Gehäusekörpers.

Die Abdeckplatte, an der der zumindest eine optoelektronische Halbleiterchip befestigt ist, ist an der zumindest einen Gehäuseseitenwand befestigt. Das heißt, der Halbleiterchip steht in dieser Ausführungsform sowohl mit dem Gehäuseboden des Gehäusekörpers als auch mit der Abdeckplatte in Kontakt und ist an beiden dieser Elemente mechanisch befestigt. Die Abdeckplatte schließt den Gehäusekörper vorzugsweise hermetisch nach außen ab, so dass der Gehäusekörper mit der Abdeckplatte einen Schutz des Halbleiterchips vor atmosphärischen Gasen und Feuchtigkeit darstellen kann. Ferner kann die Abdeckplatte einen Schutz des Lumineszenzkonversionsstoffs vor atmosphärischen Gasen und Feuchtigkeit darstellen, wenn dieser auf die Innenseite der Abdeckplatte aufgebracht ist.

Gemäß zumindest einer Ausführungsform des optoelektronischen Halbleiterbauteils schließt die Gehäuseseitenwand zumindest an ihrer dem Halbleiterchip zugewandten Seite mit dem Gehäuseboden zumindest stellenweise einen Winkel von größer als 90° ein. Vorzugsweise verläuft die Gehäuseseitenwand dann stellenweise auch in einem Winkel von größer als 90° zur Strahlungsdurchtrittsfläche des Halbleiterchips. Die Gehäuseseitenwand kann reflektierend beschichtet sein, so dass die Gehäuseseitenwand einen Reflektor von im Halbleiterchip erzeugter elektromagnetischer Strahlung darstellt.

Gemäß zumindest einer Ausführungsform des optoelektronischen Halbleiterbauteils schließt die Abdeckplatte zumindest stellenweise bündig mit der Gehäuseseitenwand ab. Das heißt, die Abdeckplatte überragt den Gehäusekörper nicht seitlich, sondern weist hinsichtlich ihrer Grundfläche beispielsweise die gleiche Form und die gleiche Größe wie die Grundfläche des Gehäusekörpers auf. Auf diese Weise lässt sich ein besonders kompaktes optoelektronisches Halbleiterbauteil realisieren. Zum Beispiel weist das Halbleiterbauteil eine äußere Form auf, die einem Quader entspricht. Das optoelektronische Halbleiterbauteil selbst kann also von seiner äußeren Form einem herkömmlichen Halbleiterchip gleichen. Beispielsweise weist das Halbleiterbauteil dabei eine Grundfläche von wenigstens 0,25 mm² und höchstens 50 mm² auf. Das optoelektronische Halbleiterbauteil selbst kann auf eine Leiterplatte montiert werden oder in den Gehäusekörper einer üblichen oberflächenmontierbaren Leuchtdiode eingebracht werden und beispielsweise mit einem transparenten Vergussmaterial vergossen werden. Insgesamt bildet das optoelektronische Halbleiterbauteil ein besonders kompaktes Halbleiterbauteil, das in seinen äußeren Abmessungen höchstens um 50 % größer ist wie der optoelektronische Halbleiterchip oder die optoelektronischen Halbleiterchips des optoelektronischen Halbleiterbauteils. Zum Beispiel ist die Grundfläche des Halbleiterbauteils höchstens um 50 % größer als die Grundfläche des optoelektronischen Halbleiterchips oder als die Summe der Grundflächen der optoelektronischen Halbleiterchips des optoelektronischen Halbleiterbauteils.

Gemäß zumindest einer Ausführungsform des optoelektronischen Halbleiterbauteils besteht der Gehäusekörper aus einem Halbleitermaterial oder einem Keramikmaterial. Auf den Gehäusekörper kann dann eine Schicht aus einem Metall abgeschieden sein, die zur Befestigung und/oder zur Kontaktierung des Halbleiterchips des Halbleiterbauteils dient. Der Gehäusekörper kann beispielsweise aus einem keramischen Material wie Aluminiumoxid oder Aluminiumnitrid oder einem Halbleitermaterial wie Silizium gebildet sein.

Gemäß zumindest einer Ausführungsform des optoelektronischen Halbleiterbauteils weist der Gehäuseboden des Gehäusekörpers zumindest einen Durchbruch auf, mittels dem der Halbleiterchip elektrisch kontaktierbar ist. Der Durchbruch reicht vom Gehäuseboden des Gehäusekörpers nach außen und stellt ein Loch im Gehäuseboden dar. Der Durchbruch kann mit einem elektrisch leitenden Material befüllt sein, über das der Halbleiterchip elektrisch angeschlossen werden kann.

Es wird weiter ein Verfahren zur Herstellung eines optoelektronischen Halbleiterbauteils angegeben. Das Verfahren umfasst gemäß einer Ausführungsform die folgenden Schritte:

Zunächst wird eine Vielzahl optoelektronischer Halbleiterchips, die jeweils eine Strahlungsdurchtrittsfläche aufweisen, bereitgestellt, wobei die Strahlungsdurchtrittsfläche je an einer Hauptfläche des jeweiligen Halbleiterchips ausgebildet ist. Die Halbleiterchips können sich beispielsweise noch im Waferverbund befinden. Es ist aber auch möglich, dass die Halbleiterchips auf einen Zwischenträger aufgebracht sind.

In einem weiteren Verfahrensschritt wird eine Abdeckplatte bereitgestellt, die derart groß gewählt ist, dass sie sämtliche optoelektronischen Halbleiterchips der Vielzahl optoelektronischer Halbleiterchips überragt.

In einem weiteren Verfahrensschritt wird die Vielzahl der optoelektronischen Halbleiterchips zum Beispiel gleichzeitig an der Abdeckplatte befestigt und elektrisch mit der Abdeckplatte kontaktiert. Dazu wird beispielsweise die Abdeckplatte über die Vielzahl der optoelektronischen Halbleiterchips an deren Strahlungsdurchtrittsflächen gelegt. Anschlussstellen an den Hauptflächen der optoelektronischen Halbleiterchips, welche die Strahlungsdurchtrittsflächen umfassen, können mittels Bondtechniken oder Löten mit Verbindungselementen, die an der Abdeckplatte ausgebildet sind, verbunden werden. Ferner können die optoelektronischen Halbleiterchips an ihren Strahlungsdurchtrittsflächen mit einem transparenten Klebstoff mit der Abdeckplatte verbunden werden.

In einem abschließenden Verfahrensschritt wird die Anordnung aus Abdeckplatte und Halbleiterchips zu einzelnen optoelektronischen Halbleiterbauteilen vereinzelt, wobei jedes Halbleiterbauteil zumindest einen optoelektronischen Halbleiterchip umfasst.

Beispielsweise wird mit dem Verfahren ein optoelektronisches Halbleiterbauteil erzeugt, wie es in Verbindung mit den vorangegangenen Ausführungsformen beschrieben ist. Das heißt, sämtliche in Verbindung mit dem optoelektronischen Halbleiterbauteil beschriebenen Merkmale sind auch in Verbindung mit dem Verfahren offenbart und umgekehrt.

Gemäß zumindest einer Ausführungsform des Verfahrens umfasst das Verfahren zusätzlich Verfahrensschritte wie folgt:

Es wird eine Vielzahl von Gehäusekörpern bereitgestellt, die jeweils einen Gehäuseboden und zumindest eine Gehäuseseitenwand umfassen. Anschließend wird die Abdeckplatte an der Vielzahl von Gehäusekörpern befestigt. Dabei wird die Abdeckplatte derart auf die Gehäusekörper gelegt, dass in jedem Gehäusekörper zumindest ein optoelektronischer Halbleiterchip angeordnet ist. Die Tiefe der Ausnehmung im jeweiligen Gehäusekörper, das heißt der Abstand zwischen der Bodenfläche des Gehäusekörpers und der Abdeckplatte, ist dabei derart gewählt, dass der Halbleiterchip sich sowohl mit der Abdeckplatte als auch mit der Bodenfläche des Gehäusekörpers zumindest in mittelbarem Kontakt befindet. Das heißt, der Halbleiterchip muss nicht in direktem Kontakt mit den beiden genannten Komponenten stehen, sondern es kann sich beispielsweise jeweils ein Verbindungsmaterial, wie ein Lotmaterial, zwischen Halbleiterchip und Gehäuseboden sowie zwischen Halbleiterchip und Abdeckplatte befinden.

Das Befestigen der Abdeckplatte kann dabei gleichzeitig mit dem Befestigen des Halbleiterchips am Gehäuseboden des Gehäusekörpers erfolgen. Beispielsweise erfolgt das Befestigen jeweils mittels eines Bondprozesses durch Erwärmen der Anordnung aus Gehäusekörper und Abdeckplatte.

Das Befestigen der Abdeckplatte an der Vielzahl von Gehäusekörpern ist vor oder nach dem Vereinzeln der Abdeckplatte möglich, so dass die Vielzahl von optoelektronischen Halbleiterchips gleichzeitig in eine Vielzahl von Gehäusekörpern eingebracht werden kann. Auch die Gehäusekörper können dabei in einem Verbund von Gehäusekörpern zusammengefasst sein. Beispielsweise ist der Verbund aus Gehäusekörpern durch eine Platte aus einem Halbleitermaterial oder einem Keramikmaterial gebildet, in das Ausnehmungen eingebracht sind, die jeweils wenigstens einen optoelektronischen Halbleiterchip aufnehmen können.

Abschließend kann der Verbund aus Abdeckplatte und Gehäusekörpern zu einzelnen optoelektronischen Halbleiterbauteilen zertrennt werden. Dies kann beispielsweise durch ein Sägen zumindest durch die Abdeckplatte und - falls diese zusammenhängen - auch durch die Vielzahl der Gehäusekörper erfolgen.

Im Folgenden wird das hier beschriebene optoelektronische Halbleiterbauteil sowie das hier beschriebene Verfahren zur Herstellung eines optoelektronischen Halbleiterbauteils anhand von Ausführungsbeispielen und den zugehörigen Figuren näher erläutert.
- Die Figuren 1 bis 5: zeigen Ausführungsbeispiele von hier beschriebenen optoelektronischen Halbleiterbauteilen in schematischen Darstellungen.
- Die Figur 6: zeigt eine schematische Draufsicht auf einen optoelektronischen Halbleiterchip, wie er in Ausführungsbeispielen von hier beschriebenen optoelektronischen Halbleiterbauteilen zum Einsatz kommen kann.
- Die Figuren 7 bis 10: zeigen anhand schematischer Darstellungen weitere Ausführungsbeispiele von hier beschriebenen optoelektronischen Halbleiterbauteilen.
- Die Figuren 11A bis 11C: zeigen anhand schematischer Schnittdarstellungen ein Ausführungsbeispiel eines hier beschriebenen Verfahrens zur Herstellung eines optoelektronischen Halbleiterbauteils.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

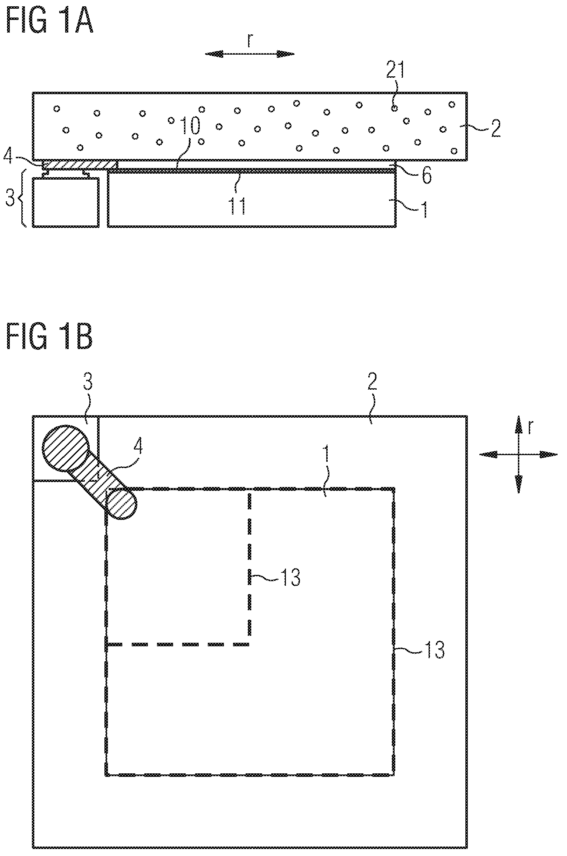

Die Figur 1A zeigt anhand einer schematischen Schnittdarstellung ein erstes Ausführungsbeispiel eines hier beschriebenen optoelektronischen Halbleiterbauteils. Die Figur 1B zeigt das Halbleiterbauteil in einer schematischen Draufsicht durch die Abdeckplatte 2 hindurch.

Das optoelektronische Halbleiterbauteil umfasst einen optoelektronischen Halbleiterchip 1, hier beispielsweise einen Leuchtdiodenchip 1. Der Halbleiterchip 1 weist eine quaderförmige Form auf. Die Deckfläche des Quaders bildet die Hauptfläche 10, welche die Strahlungsdurchtrittsfläche 11 des optoelektronischen Halbleiterchips 1 umfasst. An seiner Strahlungsdurchtrittsfläche 11 ist der optoelektronische Halbleiterchip 1 mit der Abdeckplatte 2 verbunden. Dazu kann zwischen dem optoelektronischen Halbleiterchip und der Abdeckplatte 2 ein Verbindungsmaterial 6 angeordnet sein. Beispielsweise bedeckt das Verbindungsmaterial 6 die Strahlungsdurchtrittsfläche 11 vollständig. Bei dem Verbindungsmaterial 6 kann es sich um einen strahlungsdurchlässigen Klebstoff handeln. Ferner ist der optoelektronische Halbleiterchip 1 mittels des Verbindungselements 4 mit der Abdeckplatte 2 mechanisch und elektrisch leitend verbunden.

Bei der Abdeckplatte 2 handelt es sich um einen strahlungsdurchlässigen Körper, der quaderförmig ausgebildet sein kann. Die Abdeckplatte 2 ist beispielsweise mit einem der folgenden Materialien gebildet: Glas, strahlungsdurchlässiger Kunststoff, Keramik. In die Abdeckplatte 2 können Partikel 21 eines Lumineszenzkonversionsstoffs eingebracht sein. Beispielsweise erzeugt der optoelektronische Halbleiterchip 1 im Betrieb elektromagnetische Strahlung im blauen und/oder ultravioletten Spektralbereich. Die Partikel des Lumineszenzkonversionsstoffs in der Abdeckplatte 2 konvertieren diese elektromagnetische Strahlung dann in elektromagnetischer Strahlung höherer Wellenlängen.

Darüber hinaus ist es auch möglich, dass die Abdeckplatte 2 aus einem keramischen Lumineszenzkonversionsmaterial gebildet ist und aus diesem besteht.

Das Verbindungselement 4 ist beispielsweise als dünne Metallschicht auf der dem optoelektronischen Halbleiterchip 1 zugewandten Seite der Abdeckplatte 2 aufgebracht. Beispielsweise enthält oder besteht das Verbindungselement 4 aus einem der folgenden Materialien: Titan, Platin, Silber, Rhodium, Kupfer, Gold, Aluminium, TCO. Das Verbindungselement 4 ist beispielsweise durch einen Siebdruckprozess, einen Schwammdruckprozess mit elektrisch leitfähiger Tinte - beispielsweise einer Silber- oder LTCC- (Low Temperature Cofired Ceramic) Paste, chemischer Dampfphasenepitaxie, Elektrodenstrahlabscheidung, Sputtern oder anderer Methoden auf die Abdeckplatte 2 aufgebracht.

Das Verbindungselement 4 ist vorliegend als Band ausgebildet, das mit Anschlussstellen 13 an der Hauptfläche 10 des optoelektronischen Halbleiterchips verbunden ist. Die Verbindung ist beispielsweise durch Löten oder einen thermischen Diffusionsbondprozess hergestellt. Darüber hinaus ist es möglich, dass das Verbindungselement durch einen elektrisch leitfähigen Klebstoff gebildet ist, so dass der optoelektronische Halbleiterchip 1 bereichsweise mittels des Verbindungselements an der Abdeckplatte 2 festgeklebt ist. Dabei ist es auch möglich, dass auf ein weiteres Verbindungsmittel 6 gänzlich verzichtet wird, und der optoelektronische Halbleiterchip 1 ausschließlich über das Verbindungselement 4 mit der Abdeckplatte 2 verbunden ist.

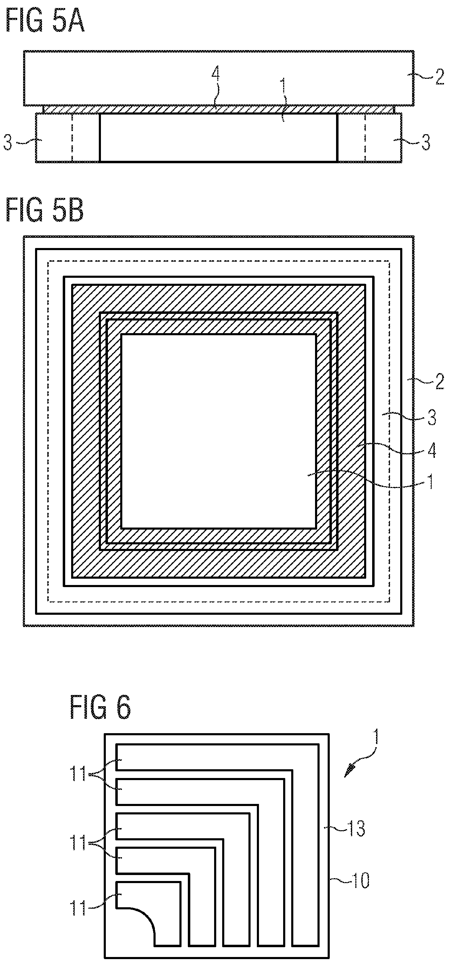

Die Anschlussstellen 13 an der Hauptfläche 10 des optoelektronischen Halbleiterchips 1, die auch die Strahlungsdurchtrittsfläche 11 umfasst, können beispielsweise als Metallbeschichtungen ausgeführt sein, welche die Hauptfläche 10 gitterartig oder in mehreren Linien bedecken, um eine ausreichende Stromaufweitung über den gesamten optoelektronischen Halbleiterchip 1 sicherzustellen (siehe dazu auch die Figur 6).

An der dem Halbleiterchip 1 zugewandten Seite der Abdeckplatte 2 ist die Kontaktstelle 3 angeordnet. Die Kontaktstelle 3 ist elektrisch leitend mit dem Verbindungselement 4 verbunden. Beispielsweise erstreckt sich die Kontaktstelle 3 seitlich entlang einer Seitenfläche des Halbleiterchips 1. Die Kontaktstelle 3 ist beabstandet zum Halbleiterchip 1 angeordnet und ebenso wie der optoelektronische Halbleiterchip 1 von der Abdeckplatte 2 überragt. Mittels der Kontaktstelle 3 kann der optoelektronische Halbleiterchip 1 beispielsweise n-seitig elektrisch kontaktiert werden. Das dargestellte optoelektronische Halbleiterbauelement kann zum elektrischen Anschluss auf eine Leiterplatte montiert werden. Das optoelektronische Halbleiterbauteil umfasst dann lediglich den optoelektronischen Halbleiterchip 1, die Abdeckplatte 2 sowie die Kontaktstelle 3. Es ist oberflächenmontierbar ausgebildet. Auf die Verbindung durch einen Kontaktdraht kann aufgrund der Verwendung des Verbindungselements 4 vorteilhaft verzichtet werden.

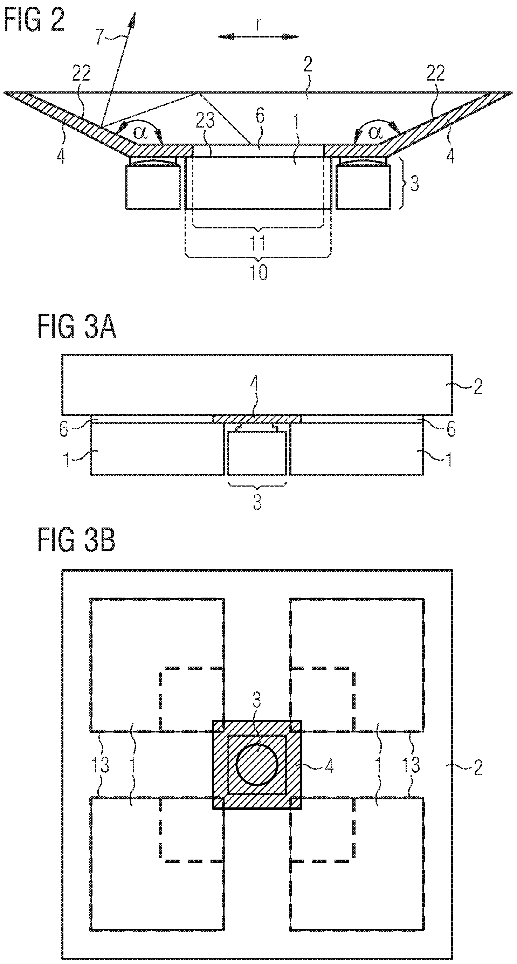

In Verbindung mit der Figur 2 ist anhand einer schematischen Schnittdarstellung ein weiteres Ausführungsbeispiel eines hier beschriebenen optoelektronischen Halbleiterbauteils näher erläutert. In diesem Ausführungsbeispiel ist die Abdeckplatte 2 reflektorartig ausgebildet. Das heißt, die Abdeckplatte 2 weist Seitenflächen 22 auf, die in einem Winkel α > 90° zur Strahlungsdurchtrittsfläche 11 des optoelektronischen Halbleiterchip 1 verlaufen. Im Querschnitt ist die Abdeckplatte 2 beispielsweise trapezförmig ausgebildet. Die dem optoelektronischen Halbleiterchip 1 zugewandte Seite der Abdeckplatte 2, das heißt die Seitenflächen 22 sowie die Bodenfläche 23, ist dort, wo sich die Strahlungsdurchtrittsfläche 11 des optoelektronischen Halbleiterchips 1 nicht befindet, vollständig vom Verbindungselement 4 bedeckt. Das Verbindungselement 4 ist elektrisch leitend und reflektierend ausgebildet und besteht beispielsweise aus einer dünnen Silberbeschichtung. Das Verbindungselement 4 nimmt eine Doppelfunktion wahr: Zum einen dient es zur Bestromung des Halbleiterchips 1 mittels der Kontaktstellen 3, zum anderen reflektiert es erzeugte elektromagnetische Strahlung 7 und konvertierte elektromagnetische Strahlung 7 weg von der Strahlungsdurchtrittsfläche 11, also in Hauptabstrahlrichtung des optoelektronischen Halbleiterchips 1.

Die Abdeckplatte 2 ist in diesem Fall beispielsweise aus einem keramischen Lumineszenzkonversionsstoff gebildet. Im Betrieb des optoelektronischen Halbleiterchips 1 und bei der Konversion von elektromagnetischer Strahlung erzeugte Wärme wird durch die großflächige Abdeckplatte 2, die den optoelektronischen Halbleiterchip 1 in lateraler Richtung R überragt, sowie die Kontaktstelle 3 besonders gut abgeführt. In Verbindung mit den schematischen Darstellungen der Figuren 3A und 3B ist anhand eines weiteren Ausführungsbeispiel eines hier beschriebenen optoelektronischen Halbleiterbauteils erläutert, dass das optoelektronische Halbleiterbauteil mehrere optoelektronische Halbleiterchips, vorliegend vier Chips, umfassen kann. Zur elektrischen Kontaktierung der vier optoelektronischen Halbleiterchips kann das Halbleiterbauteil eine einzige Kontaktstelle 3 umfassen, die mittels eines großflächigen Verbindungselements 4 mit den Halbleiterchips 1 elektrisch leitend verbunden ist. Bei den optoelektronischen Halbleiterchips 1 kann es sich dabei um optoelektronische Halbleiterchips unterschiedlicher Bauweise handeln.

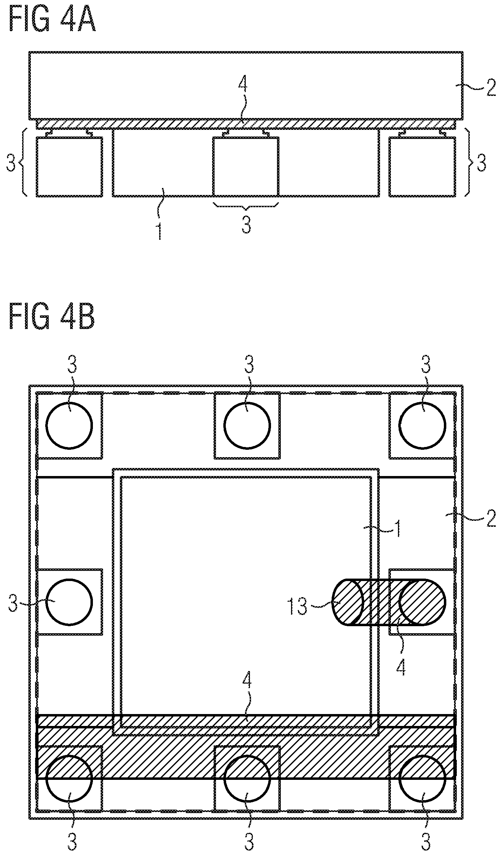

In Verbindung mit den Figuren 4A und 4B ist anhand schematischer Darstellung erläutert, dass das optoelektronische Halbleiterbauteil mehrere Kontaktstellen 3 umfassen kann. Durch die Verwendung mehrerer Kontaktstellen 3 ist beispielsweise eine verbesserte Wärmeableitung von der im Betrieb des optoelektronischen Halbleiterchips und bei der Konversion erzeugten Wärme möglich. Ferner ist die Stromverteilung in den optoelektronischen Halbleiterchip 1 verbessert. Beispielsweise kann das Verbindungselement 4 dazu rahmenartig um den optoelektronischen Halbleiterchip 1 herum angeordnet sein, so dass das Verbindungselement 4 mit sämtlichen Kontaktstellen 3 elektrisch leitend verbunden ist. Es ist jedoch auch möglich, dass das Verbindungselement 4 durch einzelne Bänder gebildet ist, die von einer Kontaktstelle 3 jeweils zum optoelektronischen Halbleiterchip 1 reichen. Schließlich ist es möglich, dass das Verbindungselement 4 streifenartig ausgebildet ist und beispielsweise die an einer Seitenfläche des Halbleiterchips 1 angeordneten Kontaktstellen 3 miteinander verbindet.

Beim in Verbindung mit den Figuren 5A und 5B beschriebenen Ausführungsbeispiel eines hier beschriebenen optoelektronischen Halbleiterbauteils weist das optoelektronische Halbleiterbauteil eine einzige Kontaktstelle 3 auf, die rahmenartig um den Halbleiterchip 1 herumgeführt ist, so dass sie den Halbleiterchip 1 vollständig seitlich umschließt. Die einzige Kontaktstelle 3 ist mittels eines rahmenartigen Verbindungselements 4, welches die Strahlungsdurchtrittsfläche 11 des Halbleiterchips 1 rahmenförmig umschließt, an den optoelektronischen Halbleiterchip 1 angeschlossen. Dies führt zu einer besonders guten und gleichmäßigen Stromeinprägung in den Halbleiterchip 1 über die gesamte Hauptfläche 10. Die Anschlussstellen 13 auf der Hauptfläche 10 des strahlungsemittierenden Halbleiterchips 1 können in diesem Fall besonders dünn ausgeführt sein. Auf diese Weise ist die Strahlungsdurchtrittsfläche 11, also diejenige Fläche der Hauptfläche 10, die nicht von den Anschlussstellen 13 bedeckt ist, besonders groß ausgebildet.

Beispielsweise die Figur 6 zeigt in einer schematischen Draufsicht die Hauptfläche 10 eines optoelektronischen Halbleiterchips, wie er in den hier beschriebenen Ausführungsbeispielen des Halbleiterbauteils Verwendung finden kann.

Im in Verbindung mit den Figuren 5A und 5B beschriebenen Ausführungsbeispiel ist es insbesondere möglich, dass der optoelektronische Halbleiterchip 1 lediglich über das großflächig ausgeführte Verbindungselement 4 mit der Abdeckplatte 2 verbunden ist und kein zusätzliches Verbindungsmittel 6 zwischen der Strahlungsdurchtrittsfläche 11 und der Abdeckplatte 2 angeordnet ist.

Das Verbindungselement 4 kann, wie in allen hier gezeigten Ausführungsbeispielen, strahlungsreflektierend oder strahlungsdurchlässig ausgebildet sein. Insbesondere im Falle eines großflächig ausgeführten Verbindungsmaterials 4, wie es beispielsweise im Ausführungsbeispiel der Figuren 5A und 5B der Fall ist, kann das Verbindungselement 4 auch durch eine TCO-Material gebildet sein.

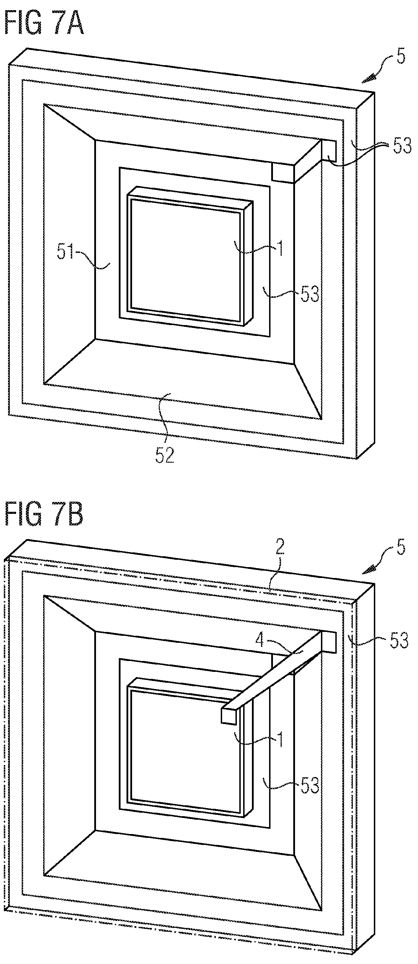

In Verbindung mit den schematischen Darstellungen der Figuren 7A bis 7C ist ein weiteres Ausführungsbeispiel eines hier beschriebenen optoelektronischen Halbleiterbauteils näher erläutert. Im Unterschied beispielsweise zum in Verbindung mit den Figuren 1A und 1B beschriebenen Ausführungsbeispiel umfasst das Halbleiterbauteil einen Gehäusekörper 5, der den optoelektronischen Halbleiterchip 1 an dessen Seitenflächen und an dessen der Hauptfläche 10 abgewandten Bodenfläche umgibt. Der Gehäusekörper 5 ist beispielsweise aus einem Halbleitermaterial oder einem Keramikmaterial gebildet. Beispielsweise ist eine Ausnehmung zur Bildung des Gehäusekörpers 5 in einen Vollkörper strukturiert. Die Ausnehmung kann beispielsweise in den Vollkörper geätzt sein.

Der Gehäusekörper 5 kann aber auch mehrteilig ausgeführt sein. In diesem Fall ist es insbesondere möglich, dass der Gehäuseboden 51 des Gehäusekörpers 5 mit einem anderen Material als die Gehäuseseitenwand 52 gebildet ist.

Der Halbleiterkörper 5 umfasst einen Gehäuseboden 51, auf den eine Metallisierung 53 aufgebracht sein kann. Auf der Metallisierung 53 kann der optoelektronische Halbleiterchip beispielsweise durch Bonden, Kleben oder Löten befestigt sein. Ferner umfasst der Gehäusekörper 5 eine Gehäuseseitenwand 52, die den optoelektronischen Halbleiterchip 1 seitlich umgibt. Die Gehäuseseitenwand 52 kann auf ihrer dem Halbleiterchip 1 zugewandten Seite einen Winkel > 90° mit dem Gehäuseboden 51 einschließen. Auf die derart schräg angeordnete Gehäuseseitenwand 52 kann stellenweise eine Metallisierung 53 aufgebracht sein, die zur Kontaktierung des optoelektronischen Halbleiterchips 1 dient. Ferner kann sich am äußeren, dem Gehäuseboden 51 abgewandten Rand der Gehäuseseitenwand 52 eine Metallisierung 53 befinden, die zur Befestigung der Abdeckplatte 2 auf dem Gehäusekörper 5 dient. Die Metallisierungen 53 können beispielsweise folgende Metalle enthalten oder aus diesen bestehen: Titan, Platin, Zinn, Gold, Silber, Aluminium oder aus Legierungen dieser Materialien.

Auf die Gehäuseseitenwand 52 und gegebenenfalls eine auf der Gehäuseseitenwand 52 angeordnete Metallisierung 53 kann eine Passivierungsschicht aufgebracht sein, die beispielsweise Siliziumoxid, Siliziumnitrid, Aluminiumnitrid oder ein anderes transparentes, elektrisch isolierendes Material enthält. Die Passivierung kann beispielsweise mittels Sputtern auf die Gehäuseseitenwand 52 aufgebracht sein. Auf der Passivierung kann ein hoch reflektierendes Material wie eine Schicht aus Silber oder Aluminium aufgebracht sein, die zur Reflexion von im Betrieb des Halbleiterchips erzeugter elektromagnetischer Strahlung dient.

Wie insbesondere aus der Figur 7B ersichtlich ist, verbindet das Verbindungselement 4 auf der Abdeckplatte 2 den optoelektronischen Halbleiterchip 1 mit der Metallisierung 53 an der Gehäuseseitenwand 52. Das Verbinden der Abdeckplatte 2 mit dem optoelektronischen Halbleiterchip 1 kann dabei nach oder vor dem Befestigen des Halbleiterchips 1 im Gehäusekörper 5 erfolgen. Das heißt, der optoelektronische Halbleiterchip 1 kann beispielsweise zusammen mit der Abdeckplatte 2, also bereits auf der Abdeckplatte 2 befestigt, am Gehäusekörper 5 befestigt werden. Das Befestigen der Abdeckplatte 2 am Gehäusekörper 5 sowie des optoelektronischen Halbleiterchips am Gehäuseboden 51 beziehungsweise der Abdeckplatte 2 am optoelektronischen Halbleiterchip 1 kann in einem einzigen Verfahrensschritt beispielsweise durch thermisches Diffusionsbonden, eutektisches Bonden oder anodisches Bonden erfolgen.

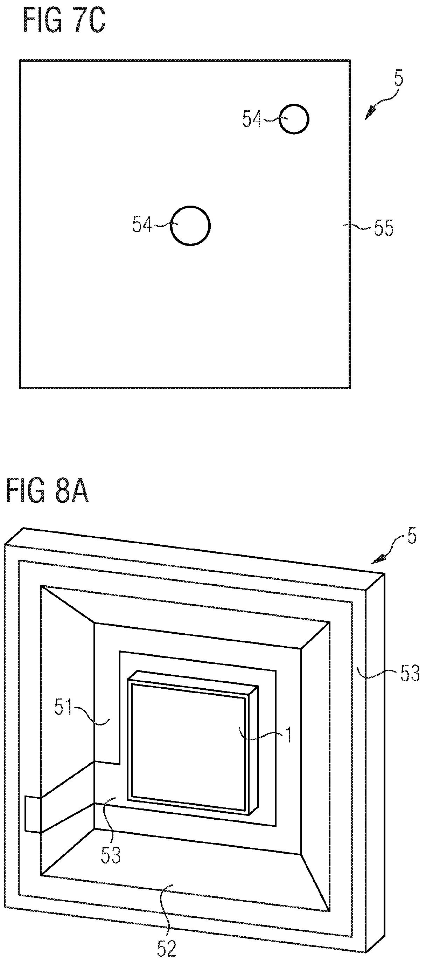

Die Figur 7C zeigt anhand einer schematischen Darstellung die Rückseite 55 des Gehäusekörpers 5. Auf der Rückseite 55 des Gehäusekörpers 5 sind zwei Durchbrüche 54 angeordnet, durch die hindurch der optoelektronische Halbleiterchip 1 elektrisch kontaktiert werden kann.

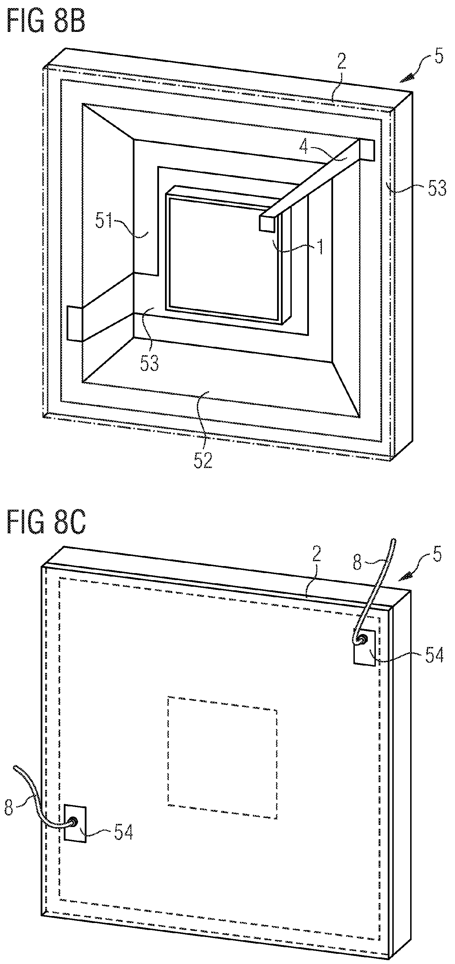

In Verbindung mit den Figuren 8A bis 8C ist anhand schematischer Darstellungen ein weiteres Ausführungsbeispiel eines hier beschriebenen optoelektronischen Halbleiterbauteils näher erläutert. In diesem Ausführungsbeispiel ist der optoelektronische Halbleiterchip 1 durch Durchbrüche 54 in der Abdeckplatte 2 über die Abdeckplatte mittels Kontaktdrähten 8 kontaktiert. An der Rückseite 55 des Gehäusebodens befinden sich dann keine Durchbrüche.

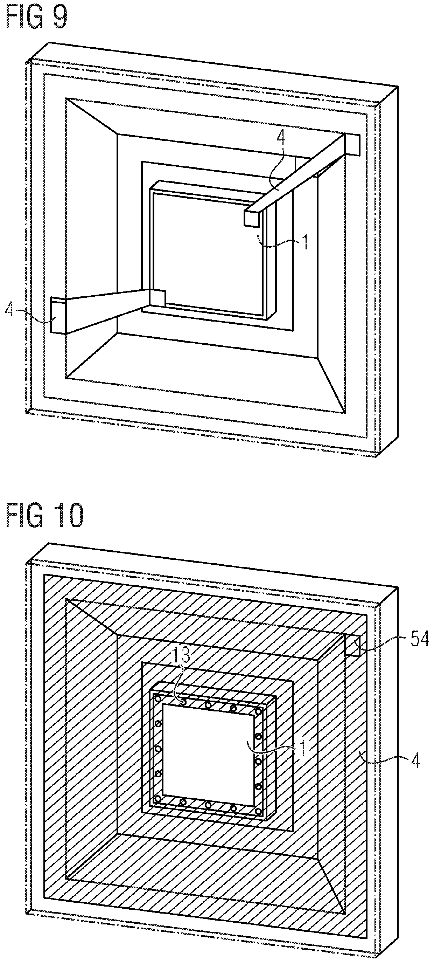

In Verbindung mit der Figur 9 ist anhand einer schematischen Darstellung ein Ausführungsbeispiel des hier beschriebenen Halbleiterbauteils näher erläutert, bei dem der optoelektronische Halbleiterchip 1 mittels zweier Verbindungselemente 4, die jeweils auf der Abdeckplatte 2 angeordnet sind, kontaktiert wird. Eine weitere Kontaktierung des Halbleiterchips 1 kann dabei von der Rückseite 55 des Gehäusekörpers 5 her erfolgen.

In Verbindung mit der Figur 10 ist ein Ausführungsbeispiel eines hier beschriebenen optoelektronischen Halbleiterbauteils anhand einer schematischen Ansicht näher erläutert, bei dem das Verbindungselement 4 großflächig auf die dem Halbleiterchip 1 zugewandte Seite der Abdeckplatte 2 aufgebracht ist. Lediglich der Bereich der Abdeckplatte, der der Strahlungsdurchtrittsfläche 11 des Halbleiterchips direkt gegenüberliegt, bleibt frei vom Verbindungselement 4.

Beispielsweise handelt es sich beim Verbindungselement 4 in diesem Fall um ein reflektierend oder strahlungsdurchlässig ausgeführtes Verbindungselement 4. Handelt es sich bei dem Verbindungselement 4 um ein strahlungsdurchlässiges Verbindungselement, so kann dieses beispielsweise durch eine Beschichtung aus einem TCO-Material gebildet sein. Die Beschichtung aus dem TCO-Material weist dabei vorzugsweise eine Dicke zwischen wenigstens 300 nm und höchstens 600 nm auf. Das Verbindungselement 4 kann mit Anschlussstellen 13 des Halbleiterchips 1 elektrisch verbunden sein, die beispielsweise als örtlich begrenzte Verbindungspunkte ausgebildet sind. Ferner ist es möglich, dass das Verbindungselement 4 im Randbereich der Hauptfläche 10 des optoelektronischen Halbleiterchips 1 großflächig mit diesem in Kontakt steht und die Strahlungsdurchtrittsfläche 11 des optoelektronischen Halbleiterchips seitlich umschließt.

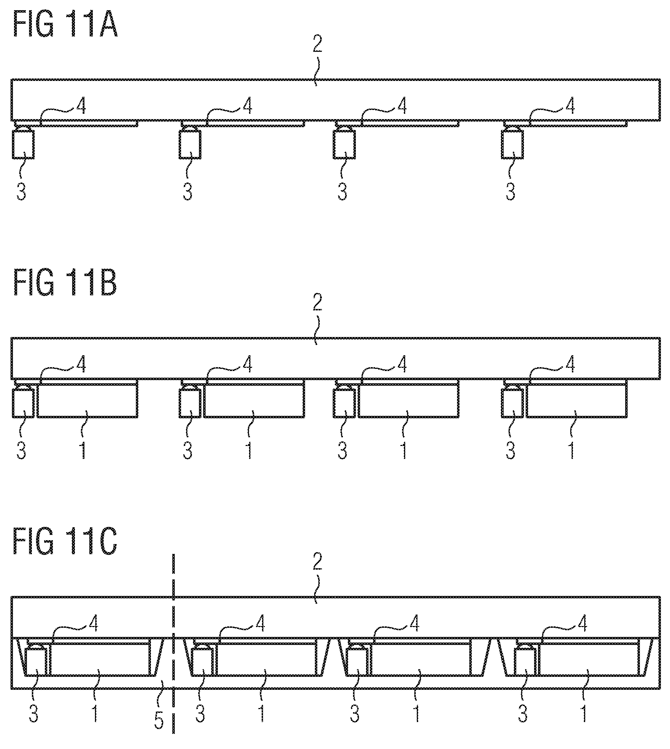

In Verbindung mit den Figuren 11A bis 11C ist anhand schematischer Schnittdarstellungen ein Ausführungsbeispiel eines hier beschriebenen Verfahrens zur Herstellung eines optoelektronischen Halbleiterbauteils näher erläutert. Im in Verbindung mit der Figur 11A dargestellten Verfahrensschritt wird zunächst eine Abdeckplatte 2 bereitgestellt, die mit einer Vielzahl von Kontaktstellen 3 versehen ist, die sich jeweils mit Verbindungselementen 4 in Kontakt befinden.

In einem weiteren Verfahrensschritt, siehe die Figur 11B, wird eine Vielzahl von optoelektronischen Halbleiterchips 1 über die Verbindungselemente 4 und gegebenenfalls ein Verbindungsmittel 6 mit der Abdeckplatte 2 verbunden. Dabei können sämtliche optoelektronische Halbleiterchips 1 gleichzeitig mit der Abdeckplatte 2 verbunden werden.

In einem weiteren Verfahrensschritt 11C werden die optoelektronischen Halbleiterchips 1 und die Kontaktstellen 3 mit Gehäusekörpern 5 verbunden, die einzeln oder, wie in der Figur 11C dargestellt, im Verbund vorliegen können. Es ist auch möglich, dass die optoelektronischen Halbleiterchips 1 zunächst mit den Gehäusekörpern 5 verbunden werden und die Abdeckplatte 2 dann auf die bereits in den Gehäusekörpern 5 befestigten oder eingebrachten optoelektronischen Halbleiterchips 1 aufgebracht wird. Insbesondere kann ein Befestigen der Abdeckplatte 2 mit den optoelektronischen Halbleiterchips 1 und ein Befestigen der optoelektronischen Halbleiterchips 1 am Gehäusekörper 5 dann im gleichen Verfahrensschritt, beispielsweise durch Erwärmen der gesamten Anordnung, erfolgen.

In einem abschließenden Verfahrensschritt kann die Anordnung aus Abdeckplatte 2, optoelektronischen Halbleiterchip 1 und Gehäusekörper 5 dann zu optoelektronischen Halbleiterbauteilen vereinzelt werden.

## Patentansprüche

1. Optoelektronisches Halbleiterbauteil mit
- zumindest einem optoelektronischen Halbleiterchip (1), der eine Strahlungsdurchtrittfläche (11) aufweist, wobei die Strahlungsdurchtrittfläche (11) an einer Hauptfläche (10) des Halbeiterchips (1) ausgebildet ist,
- einer Abdeckplatte (2), die am optoelektronischen Halbleiterchip (1) befestigt ist und die gesamte Strahlungsdurchtrittfläche (11) des Halbleiterchips (1) überspannt, wobei die Abdeckplatte (2) den Halbleiterchip (1) seitlich überragt,
- einer Kontaktstelle (3), die an der dem Halbleiterchip (1) zugewandten Seite der Abdeckplatte (2) an der Abdeckplatte (2) befestigt ist, und
- einem Gehäusekörper (5), der einen Gehäuseboden (51) umfasst, auf dem der Halbleiterchip (1) befestigt ist und zumindest eine Gehäuseseitenwand (52), die den Halbleiterchip seitlich umschließt, wobei
- die Gehäuseseitenwand (52) einstückig mit dem Gehäuseboden (51) ausgebildet ist,
- die Abdeckplatte (2) an der zumindest einen Gehäuseseitenwand (52) befestigt ist,
- die Kontaktstelle (3) mittels eines Verbindungselements (4) mit zumindest einer Anschlussstelle (13) des Halbleiterchips (1) elektrisch leitend verbunden ist, und
- die Anschlussstelle (13) an der Hauptfläche (10) des Halbeiterchips (1) angeordnet ist, **dadurch gekennzeichnet, dass** der Gehäusekörper (5) aus einem Halbleitermaterial oder einem Keramikmaterial besteht.

2. Optoelektronisches Halbleiterbauteil gemäß dem vorherigen Anspruch, bei dem
das Verbindungselement (4) auf der dem Halbleiterchip (1) zugewandten Seite der Abdeckplatte (2) an der Abdeckplatte (2) befestigt ist.

3. Optoelektronisches Halbleiterbauteil gemäß einem der vorherigen Ansprüche, bei dem
das Verbindungselement (4) die Abdeckplatte (2) an ihrer dem Halbleiterchip (1) zugewandten Seite bis auf einen Bereich an der Strahlungsdurchtrittfläche (13) des Halbleiterchips (1) vollständig bedeckt.

4. Optoelektronisches Halbleiterbauteil gemäß einem der vorherigen Ansprüche, bei dem
das Verbindungselement (4) strahlungsdurchlässig oder strahlungsreflektierend ist.

5. Optoelektronisches Halbleiterbauteil gemäß einem der vorherigen Ansprüche, bei dem
das Verbindungselement (4) die Strahlungsdurchtrittfläche (11) des Halbleiterchips (1) seitlich vollständig umschließt.

6. Optoelektronisches Halbleiterbauteil gemäß einem der vorherigen Ansprüche, bei dem
die Kontaktstelle (3) den Halbleiterchip (1) seitlich vollständig umschließt.

7. Optoelektronisches Halbleiterbauteil gemäß einem der vorherigen Ansprüche, bei dem
die Abdeckplatte (2) einen Lumineszenzkonversionsstoff umfasst.

8. Optoelektronisches Halbleiterbauteil gemäß dem vorherigen Anspruch, bei dem
die Abdeckplatte aus keramischem Material besteht, in das ein Lumineszenzkonversionsmaterial eingebracht ist oder das ein Lumineszenzkonversionsmaterial bildet.

9. Optoelektronisches Halbleiterbauteil gemäß einem der vorherigen Ansprüche, bei dem
die Gehäuseseitenwand (52) mit dem Gehäuseboden (51) stellenweise einen Winkel von größer als 90° einschließt.

10. Optoelektronisches Halbleiterbauteil gemäß einem der vorherigen Ansprüche, bei dem
die Abdeckplatte (2) zumindest stellenweise bündig mit der Gehäuseseitenwand (52) abschließt.

11. Optoelektronisches Halbleiterbauteil gemäß einem der vorherigen Ansprüche, bei dem
der Gehäusekörper (5) aus Aluminiumoxid, Aluminiumnitrid oder Silizium besteht.

12. Optoelektronisches Halbleiterbauteil gemäß einem der vorherigen Ansprüche, bei dem
der der Gehäuseboden (51) zumindest einen Durchbruch (54) aufweist, durch den der Halbleiterchip (1) elektrisch kontaktierbar ist.

13. Verfahren zur Herstellung eines optoelektronischen Halbleiterbauteils gemäß einem der Ansprüche 1 bis 12 mit den folgenden Schritten:
- Bereitstellen einer Vielzahl optoelektronischer Halbleiterchips (1), die jeweils eine Strahlungsdurchtrittfläche (11) aufweisen, wobei die Strahlungsdurchtrittfläche (11) an einer Hauptfläche (10) des jeweiligen Halbeiterchips ausgebildet ist,
- Bereitstellen einer Abdeckplatte (2),
- insbesondere gleichzeitiges Befestigen und elektrisches Kontaktieren der Vielzahl von optoelektronischen Halbleiterchips (1) an der Abdeckplatte (2), wobei die Strahlungsdurchtrittsflächen (11) der optoelektronischen Halbleiterchips (1) der Abdeckplatte (2) zugewandt sind,
- Vereinzeln der Anordnung aus Abdeckplatte (2) und den Halbleiterchips (1) zu einzelnen optoelektronischen Halbleiterbauteilen, wobei jedes Halbleiterbauteil zumindest einen optoelektronischen Halbleiterchip (1) umfasst-Bereitstellen einer Vielzahl von Gehäusekörpern (5), die jeweils einen Gehäuseboden (51) und zumindest eine Gehäuseseitenwand (52) umfassen, und
- Befestigen der Abdeckplatte (2) an der Vielzahl von Gehäusekörpern.

## Claims

1. Optoelectronic semiconductor component comprising
- at least one optoelectronic semiconductor chip (1) having a radiation passage surface (11), wherein the radiation passage surface (11) is formed at a main surface (10) of the semiconductor chip (1),
- a covering plate (2), which is fixed to the optoelectronic semiconductor chip (1) and spans the entire radiation passage surface (11) of the semiconductor chip (1), wherein the covering plate (2) projects laterally beyond the semiconductor chip (1),
- a contact location (3) fixed to the covering plate (2) at that side of the covering plate (2) which faces the semiconductor chip (1), and
- a housing body (5) comprising a housing base (51), on which the semiconductor chip (1) is fixed, and at least one housing side wall (52) that laterally encloses the semiconductor chip, wherein
- the housing side wall (52) is formed integrally with the housing base (51),
- the covering plate (2) is fixed to the at least one housing side wall (52),
- the contact location (3) is electrically conductively connected to at least one terminal location (13) of the semiconductor chip (1) by means of a connection element (4) and
- the terminal location (13) is arranged at the main surface (10) of the semiconductor chip (1), **characterized in that** the housing body (5) consists of a semiconductor material or a ceramic material.

2. Optoelectronic semiconductor component according to the preceding claim, wherein
the connection element (4) is fixed to the covering plate (2) on that side of the covering plate which faces the semiconductor chip (1).

3. Optoelectronic semiconductor component according to either of the preceding claims, wherein
the connection element (4) completely covers the covering plate (2) at the side thereof facing the semiconductor chip (1), apart from a region at the radiation passage surface (13) of the semiconductor chip (1).

4. Optoelectronic semiconductor component according to any of the preceding claims, wherein
the connection element (4) is radiation-transmissive or radiation-reflective.

5. Optoelectronic semiconductor component according to any of the preceding claims, wherein
the connection element (4) laterally completely encloses the radiation passage surface (11) of the semiconductor chip (1).

6. Optoelectronic semiconductor component according to any of the preceding claims, wherein
the contact location (3) laterally completely encloses the semiconductor chip (1).

7. Optoelectronic semiconductor component according to any of the preceding claims, wherein
the covering plate (2) comprises a luminescence conversion substance.

8. Optoelectronic semiconductor component according to the preceding claim, wherein
the covering plate consists of ceramic material into which a luminescence conversion material is introduced or which forms a luminescence conversion material.

9. Optoelectronic semiconductor component according to any of the preceding claims, wherein
the housing side wall (52) forms with the housing base (51) in places an angle of greater than 90°.

10. Optoelectronic semiconductor component according to any of the preceding claims, wherein
the covering plate (2) terminates flush with the housing side wall (52) at least in places.

11. Optoelectronic semiconductor component according to any of the preceding claims, wherein
the housing body (5) consists of aluminium oxide, aluminium nitride or silicon.

12. Optoelectronic semiconductor component according to any of the preceding claims, wherein
the housing base (51) has at least one perforation (54) through which the semiconductor chip (1) is electrically contactable.

13. Method for producing an optoelectronic semiconductor chip according to any of Claims 1 to 12 comprising the following steps:
- providing a multiplicity of optoelectronic semiconductor chips (1) each having a radiation passage surface (11), wherein the radiation passage surface (11) is formed at a main surface (10) of the respective semiconductor chip,
- providing a covering plate (2),
- in particular simultaneously fixing and electrically contacting the multiplicity of optoelectronic semiconductor chips (1) to the covering plate (2), wherein radiation passage surfaces (11) of the optoelectronic semiconductor chips (1) face the covering plate (2),
- singulating the arrangement of the covering plate (2) and semiconductor chips (1) to form individual optoelectronic semiconductor components, wherein each semiconductor component comprises at least one optoelectronic semiconductor chip (1),
- providing a multiplicity of housing bodies (5) each comprising a housing base (51) and at least one housing side wall (52), and
- fixing the covering plate (2) to the multiplicity of housing bodies.

## Revendications

1. Composant optoélectronique semi-conducteur présentant
- au moins une puce optoélectronique semi-conductrice (1) qui présente une surface (11) traversée par un rayonnement, la surface (11) traversée par un rayonnement étant formée sur une surface principale (10) de la puce semi-conductrice (1),
- une plaque de recouvrement (2) fixée sur la puce optoélectronique semi-conductrice (1) et recouvrant la totalité de la surface (11) traversée par un rayonnement de la puce semi-conductrice (1), la plaque de recouvrement (2) débordant latéralement de la puce semi-conductrice (1),
- un emplacement de contact (3) fixé sur la plaque de recouvrement (2) sur le côté de la plaque de recouvrement (2) tourné vers la puce semi-conductrice (1),
- un corps de boîtier (5) qui comporte un fond de boîtier (51) sur lequel la puce semi-conductrice (1) est fixée et
- au moins une paroi latérale (52) de boîtier qui entoure latéralement la puce semi-conductrice,
- la paroi latérale (52) de boîtier étant formée d'un seul tenant avec le fond (51) du boîtier,
- la plaque de recouvrement (2) étant fixée sur la ou les parois latérales (52) du boîtier,
- l'emplacement de contact (3) étant raccordé de manière électriquement conductrice à au moins un emplacement de raccordement (13) de la puce semi-conductrice (1) au moyen d'un élément de liaison (4) et
- l'emplacement de raccordement (13) étant disposé sur la surface principale (10) de la puce semi-conductrice (1),
**caractérisé en ce que**
- le corps (5) du boîtier est constitué d'un matériau semi-conducteur ou d'un matériau céramique.

2. Composant optoélectronique semi-conducteur selon la revendication précédente, dans lequel l'élément de liaison (4) est fixé sur la plaque de recouvrement (2) sur le côté de la plaque de recouvrement (2) tourné vers la puce semi-conductrice (1).

3. Composant optoélectronique semi-conducteur selon l'une des revendications précédentes, dans lequel l'élément de liaison (4) recouvre complètement la plaque de recouvrement (2) sur son côté tourné vers la puce semi-conductrice (1), sur une partie raccordée à la surface (13) traversée par un rayonnement de la puce semi-conductrice (1).

4. Composant optoélectronique semi-conducteur selon l'une des revendications précédentes, dans lequel l'élément de liaison (4) est transparent pour le rayonnement ou réfléchissant pour le rayonnement.

5. Composant optoélectronique semi-conducteur selon l'une des revendications précédentes, dans lequel l'élément de liaison (4) entoure complètement le côté de la surface (11) de la puce semi-conductrice (1) traversée par un rayonnement.

6. Composant optoélectronique semi-conducteur selon l'une des revendications précédentes, dans lequel l'emplacement de contact (3) entoure complètement le côté de la puce semi-conductrice (1).

7. Composant optoélectronique semi-conducteur selon l'une des revendications précédentes, dans lequel la plaque de recouvrement (2) comporte un matériau de conversion de luminescence.

8. Composant optoélectronique semi-conducteur selon l'une des revendications précédentes, dans lequel la plaque de recouvrement est constituée d'un matériau céramique dans lequel un matériau de conversion de la luminescence est incorporé ou forme le matériau de conversion de luminescence.

9. Composant optoélectronique semi-conducteur selon l'une des revendications précédentes, dans lequel la paroi latérale (52) du boîtier forme avec le fond (51) du boîtier un angle supérieur à 90° en certains emplacements.

10. Composant optoélectronique semi-conducteur selon l'une des revendications précédentes, dans lequel la plaque de recouvrement (2) se raccorde à chant à la paroi latérale (52) du boîtier au moins en certains emplacements.

11. Composant optoélectronique semi-conducteur selon l'une des revendications précédentes, dans lequel le corps (5) du boîtier est constitué d'oxyde d'aluminium, de nitrure d'aluminium ou de silicium.

12. Composant optoélectronique semi-conducteur selon l'une des revendications précédentes, dans lequel le fond (51) du boîtier présente au moins une perforation (54) par laquelle la puce semi-conductrice (1) peut être mise en contact électrique.

13. Procédé de fabrication d'un composant optoélectronique semi-conducteur selon l'une des revendications 1 à 12, le procédé comportant les étapes suivantes:
- préparation de plusieurs puces optoélectroniques semi-conductrices (1) qui présentent chacune une surface (11) traversée par un rayonnement, la surface (11) traversée par un rayonnement étant formée sur une surface principale (10) de chaque puce semi-conductrice,
- préparation d'une plaque de recouvrement (2),
- fixation et mise en contact électrique, en particulier simultanément, des différentes puces semi-conductrices optoélectroniques (1) sur la plaque de recouvrement (2), les surfaces (11) traversées par un rayonnement des puces semi-conductrices optoélectroniques (1) étant tournées vers la plaque de recouvrement (2),
- découpe de l'ensemble constitué de la plaque de recouvrement (2) et des puces semi-conductrices (1) en différents composants optoélectroniques semi-conducteurs, chaque composant semi-conducteur comprenant au moins une puce semi-conductrice optoélectronique (1),
- préparation de plusieurs corps (5) de boîtier qui comprennent chacun un fond (51) de boîtier et au moins une paroi latérale (52) de boîtier et
- fixation de la plaque de recouvrement (2) sur les différents corps de boîtier.
